# EUROPEAN PATENT APPLICATION

(11) **EP 4 723 835 A1**
(43) Date of publication of application: **08.04.2026**
(21) Application number: 25191502.1
(22) Date of filing: 24.07.2025
(51) Int. Cl.: H10D 88/00, H10D 84/85, H10D 84/01, H10D 30/00, H10D 30/43, H10D 30/01, H10D 84/03

(54) **INTEGRATED CIRCUIT DEVICES INCLUDING STACKED TRANSISTORS AND METHODS OF FABRICATION THE SAME**

(30) Priority: 02.10.2024 US 202463702360 P; 10.03.2025 US 202519075121
(71) Applicant: SAMSUNG ELECTRONICS CO., LTD., Yeongtong-gu Suwon-si, Gyeonggi-do 16677 (KR)
(72) Inventor: PARK, Beomjin, 16677 Suwon-si, Gyeonggi-do (KR); KIM, Johnsoo, 16677 Suwon-si, Gyeonggi-do (KR); PARK, Junmo, 16677 Suwon-si, Gyeonggi-do (KR); PARK, Inwon, 16677 Suwon-si, Gyeonggi-do (KR); SEO, Kang-ill, San Jose, CA, 95134 (US)
(74) Representative: Kuhnen & Wacker Patent- und Rechtsanwaltsbüro PartG mbB

(57) **Abstract**

Integrated circuit devices and methods of forming the same are provided. The integrated circuit devices may include a substrate (100); an insulator (110) on an upper surface of the substrate (100); a transistor (140) between the substrate (100) and the insulator (110), the transistor (140) comprising: channel layers (102) that are spaced apart from each other in a first direction that is perpendicular to the upper surface of the substrate (100); and a gate structure (104, 106, 108) on the channel layers and the insulator (110), wherein a width (W1) of the insulator (110) in a second direction that is parallel with the upper surface of the substrate (100) is equal or substantially equal to a width (W1) of an uppermost one of the channel layers (102) in the second direction.

## Description

### TECHNICAL FIELD

The present disclosure generally relates to the field of integrated circuit devices and, more particularly, to integrated circuit devices including stacked transistors.

### BACKGROUND

Various structures of an integrated circuit device and methods of forming the same have been proposed to increase the integration density. For example, a stacked transistor structure including multiple transistors vertically stacked has been proposed.

### SUMMARY

An integrated circuit device, according to some embodiments, may include a substrate; an insulator on an upper surface of the substrate; a transistor between the substrate and the insulator, the transistor comprising: channel layers that are spaced apart from each other in a first direction that is perpendicular to the upper surface of the substrate; and a gate structure on the channel layers and the insulator, wherein a width of the insulator in a second direction that is parallel with the upper surface of the substrate is equal or substantially equal to a width of an uppermost one of the channel layers in the second direction.

An integrated circuit device, according to some embodiments, may include a first transistor on a substrate; a second transistor on the first transistor; and an inter-gate insulator between the first transistor and the second transistor, wherein the first transistor comprises: first channel layers that are spaced apart from each other in a vertical direction that is perpendicular to an upper surface of the substrate; and a first gate structure on the first channel layers and the inter-gate insulator, wherein the second transistor comprises: second channel layers that are spaced apart from each other in the vertical direction; and a second gate structure on the second channel layers and the inter-gate insulator, wherein the first gate structure is in contact with the second gate structure, and wherein side surfaces of the inter-gate insulator are aligned with corresponding side surfaces of an uppermost one of the first channel layers, respectively.

A method of forming an integrated circuit device, according to some embodiments, may include forming a first stack on a substrate, wherein the first stack comprises first channel layers and first sacrificial layers that are alternately stacked; forming an inter-gate sacrificial layer on the first stack; forming a second stack on the inter-gate sacrificial layer, wherein the second stack comprises second channel layers and second sacrificial layers that are alternately stacked; and replacing the inter-gate sacrificial layer with an inter-gate insulator, wherein a width of the inter-gate insulator in a horizontal direction that is parallel with an upper surface of the substrate is equal or substantially equal to a width of an uppermost one of the first channel layers in the horizontal direction.

### BRIEF DESCRIPTION OF THE DRAWINGS

FIG. 1 is a cross-sectional view of an integrated circuit device according to some embodiments.
FIG. 2 is a flowchart of methods of forming an integrated circuit device according to some embodiments.
FIGS. 3 through 7 are cross-sectional views illustrating methods of forming an integrated circuit device according to some embodiments.
FIG. 8 is a cross-sectional view of an integrated circuit device according to some embodiments.
FIGS. 9 through 13 are cross-sectional views illustrating methods of forming an integrated circuit device according to some embodiments.
FIG. 14 is a cross-sectional view of an integrated circuit device according to some embodiments.
FIG. 15 is a cross-sectional view of an integrated circuit device according to some embodiments.
FIG. 16 is a cross-sectional view of an integrated circuit device according to some embodiments.
FIG. 17 is a flowchart of methods of forming an integrated circuit device according to some embodiments.
FIGS. 18 through 22 are cross-sectional views illustrating methods of forming an integrated circuit device according to some embodiments.
FIG. 23 is a cross-sectional view of an integrated circuit device according to some embodiments.
FIGS. 24 through 28 are cross-sectional views illustrating methods of forming an integrated circuit device according to some embodiments.

### DETAILED DESCRIPTION OF EMBODIMENTS

Pursuant to embodiments herein, an integrated circuit device may include a stacked transistor structure including a first transistor (e.g., a lower transistor) and a second transistor (e.g., an upper transistor) vertically stacked on a substrate. The first transistor may comprise first channel layers (e.g., lower channel layers) that are spaced apart from each other in a vertical direction. The first transistor may further comprise first gate insulators (e.g., lower gate insulators) on the first channel layers, first work function layers (e.g., lower work function layers) on the first gate insulators, and a first gate electrode (e.g., a lower gate electrode) on the first work function layers. The second transistor may comprise second channel layers (e.g., upper channel layers) that are spaced apart from each other in the vertical direction. The second transistor may further comprise second gate insulators (e.g., upper gate insulators) on the second channel layers, second work function layers (e.g., upper work function layers) on the second gate insulators, and a second gate electrode (e.g., an upper gate electrode) on the second work function layers. In some embodiments, each of the first channel layers and each of the second channel layers may be a nanosheet or a nanowire. The integrated circuit device may comprise a first insulator (also referred to as an inter-gate insulator or a middle dielectric isolation) between the first transistor and the second transistor in the vertical direction. A width of the first insulator in a horizontal direction may be equal or substantially equal to a width of an uppermost one of the first channel layers in the horizontal direction. The integrated circuit device may further comprise a second insulator (also referred to as an upper insulator) on the second transistor. The first insulator and the second insulator may be opposite to each other in the vertical direction with the second transistor therebetween. A width of the second insulator in the horizontal direction may be equal or substantially equal to a width of an uppermost one of the second channel layers in the horizontal direction. The width of the first insulator in the horizontal direction may be greater than a width of a lowermost one of the second channel layers in the horizontal direction. A width (a first width) of each of the first channel layers in the horizontal direction may be equal or substantially equal. A width (a second width) of each of the second channel layers in the horizontal direction may be equal or substantially. The first width may be greater than the second width. Herein, "substantially" may mean no greater than a 10% deviation. For example, when element X has a width of 10nm and a width of element Y is substantially equal to that of element X, the width of element Y may not be less than 9nm or greater than 11nm.

Example embodiments will be described in greater detail with reference to the attached figures.

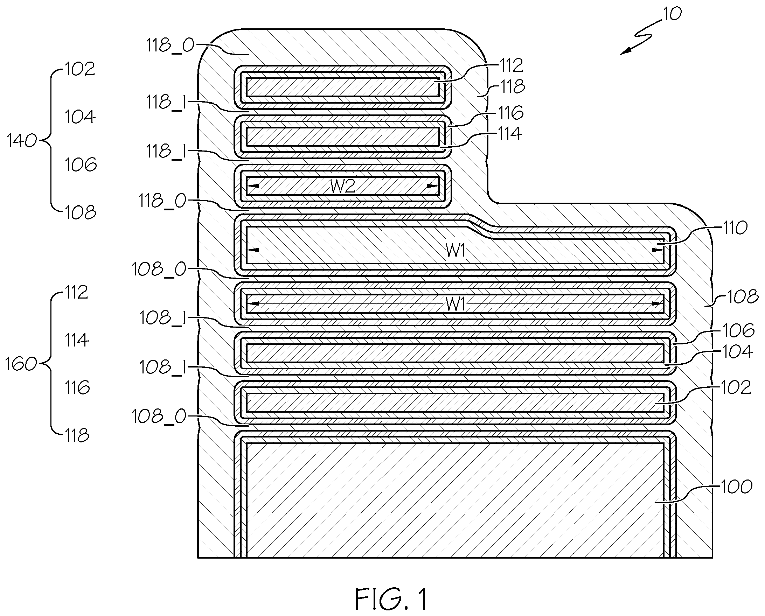

FIG. 1 is a cross-sectional view of an integrated circuit device 10 according to some embodiments. Referring to FIG. 1, the integrated circuit device 10 may include a first transistor 140 (e.g., a lower transistor 140) and a second transistor 160 (e.g., an upper transistor 160) formed on a substrate 100. The first transistor 140 may be between the substrate 100 and the second transistor 160 (in a vertical direction that is perpendicular to an upper surface and/or a lower surface of the substrate 100). In some embodiments, the center of the first transistor 140 and the center of the second transistor 160 may be misaligned with each other in the vertical direction. The first transistor 140 and the second transistor 160 may have different conductivity types or the same conductivity type. In some embodiments, the first transistor 140 may be an N-type transistor including an N-type source/drain region (not illustrated), and the second transistor 160 may be a P-type transistor including a P-type source/drain region (not illustrated). However, the inventive concepts of the types of the first transistor 140 and the second transistor 160 are not limited to the embodiments described above. For example, the first transistor 140 may be a P-type transistor including a P-type source/drain region (not illustrated), and the second transistor 160 may be an N-type transistor including an N-type source/drain region (not illustrated).

The substrate 100 may include semiconductor material(s), for example, Si, Ge, SiGe, GaP, GaAs, SiC, SiGeC and/or InP and/or may include insulating material(s), for example, silicon oxide, silicon oxynitride, silicon nitride, silicon carbonitride and/or a low-k material. In some embodiments, the substrate 100 may be a bulk substrate (e.g., a silicon wafer), a semiconductor on insulator (SOI) substrate or an insulating layer (e.g., a monolithic insulating layer). The low-k material may have a lower dielectric constat than that of silicon oxide (e.g., SiO). The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

The first transistor 140 may comprise first channel layers 102 (e.g., lower channel layers 102), first gate insulators 104 (e.g., lower gate insulators 104) on the first channel layers 102, first work function layers 106 (e.g., lower work function layers 106) on the first gate insulators 104, and a first gate electrode 108 (e.g., a lower gate electrode 108) on the first work function layers 106. The first gate insulators 104, the first work function layers 106, and the first gate electrode 108 may be collectively referred to as a first gate structure (e.g., a lower gate structure).

The first channel layers 102 may be spaced apart from each other in the vertical direction. In some embodiments, the first channel layers 102 may be spaced apart from each other at equal or substantially equal distance in the vertical direction. In some embodiments, each of the first channel layers 102 may have an equal or a substantially equal width in a horizontal direction that is parallel with the upper surface and/or the lower surface of the substrate 100. For example, each of the first channel layers 102 may have a first width W1 in the horizontal direction.

In a cross-sectional view, the first gate insulators 104 may extend around (e.g., at least partially surround) the first channel layers 102, respectively. The first work function layers 106 may extend around (e.g., at least partially surround) the first gate insulators 104, respectively. The first gate electrode 108 may extend around (e.g., at least partially surround) the first work function layers 106.

In some embodiments, the first channel layers 102 may include semiconductor material(s), for example, Si, Ge, SiGe, GaP, GaAs, SiC, SiGeC and/or InP. In some embodiments, the first gate insulators 104 may include insulator(s), for example, silicon oxide, silicon oxynitride, silicon nitride, silicon carbonitride and/or a low-k material that has a lower dielectric constant than that of silicon oxide. In some embodiments, the first work function layers 106 may include, for example, a TiN layer, a TaN layer, a TiAl layer, a TiC layer, a TiAlC layer, a TiAlN layer and/or a WN layer. In some embodiments, the first gate electrode 108 may include, for example, tungsten (W), aluminum (Al) and/or copper (Cu). However, the materials in the first channel layers 102, the first gate insulators 104, the first work function layers 106, and the first gate electrode 108 are not limited to the embodiments described above.

The first gate electrode 108 may comprise a first inner gate electrode 108_I and a first outer gate electrode 108_O. The first inner gate electrode 108_I may be between adjacent ones of the first channel layers 102 in the vertical direction. The first outer gate electrode 108_O may be on an upper surface of the uppermost one of the first channel layers 102 and/or on a lower surface of the lowermost one of the first channel layers 102. For example, the first outer gate electrode 108_O may be between the uppermost one of the first channel layers 102 and the first insulator 110 (which will be described in detail later) in the vertical direction. The first outer gate electrode 108_O may be between the lowermost one of the first channel layers 102 and the substrate 100 in the vertical direction. In some embodiments, the first inner gate electrode 108_I and the first outer gate electrode 108_O may be integrally formed (united) to constitute the first gate electrode 108.

In some embodiments, a thickness of the first gate structure between adjacent ones of the first channel layers 102 in the vertical direction and a thickness of the first gate structure between the uppermost one of the first channel layers 102 and the first insulator 110 (which will be described in detail below) in the vertical direction may be equal or substantially equal. In some embodiments, the thickness of the first gate structure between adjacent ones of the first channel layers 102 in the vertical direction and a thickness of the first gate structure between the lowermost one of the first channel layers 102 and the substrate 100 in the vertical direction may be equal or substantially equal. For example, a thickness of the first inner gate electrode 108_I in the vertical direction may be equal or substantially equal to a thickness of the first outer gate electrode 108_O in the vertical direction.

As the thickness of the first inner gate electrode 108_I in the vertical direction is equal or substantially equal to the thickness of the first outer gate electrode 108_O in the vertical direction by forming the width of the first insulator 110 in the horizontal direction equal or substantially equal to the width of the uppermost one of the first channel layers 102 in the horizontal direction, the performance of the integrated circuit device 10 (e.g., the first transistor 140) may be improved. For example, the sub-threshold swing and/or the hump in the I-V curve of the integrated circuit device 10 (e.g., the first transistor 140) may be improved (e.g., reduced) as the thickness of the first inner gate electrode 108_I in the vertical direction is equal or substantially equal to the thickness of the first outer gate electrode 108_O in the vertical direction.

The second transistor 160 may comprise second channel layers 112 (e.g., upper channel layers 112), second gate insulators 114 (e.g., upper gate insulators 114) on the second channel layers 112, second work function layers 116 (e.g., upper work function layers 116) on the second gate insulators 114, and a second gate electrode 118 (e.g., an upper gate electrode 118) on the second work function layers 116. The second gate insulators 114, the second work function layers 116, and the second gate electrode 118 may be collectively referred to as a second gate structure (e.g., an upper gate structure).

The second channel layers 112 may be spaced apart from each other in the vertical direction. In some embodiments, the second channel layers 112 may be spaced apart from each other at equal or substantially equal distance in the vertical direction. In some embodiments, each of the second channel layers 112 may have an equal or a substantially equal width in the horizontal direction. A width of at least one of the first channel layers 102 in the horizontal direction may be greater than a width of at least one of the second channel layers 112 in the horizontal direction. In some embodiments, each of the second channel layers 112 may have a second width W2 in the horizontal direction. For example, the first width W1 of each of the first channel layers 102 may be greater than the second width W2 of each of the second channel layers 112.

In a cross-sectional view, the second gate insulators 114 may extend around (e.g., at least partially surround) the second channel layers 112, respectively. The second work function layers 116 may extend around (e.g., at least partially surround) the second gate insulators 114, respectively. The second gate electrode 118 may extend around (e.g., at least partially surround) the second work function layers 116. In some embodiments, the first gate structure may be in contact with the second gate structure. For example, the second gate electrode 118 may be in contact with the first gate electrode 108. The first gate electrode 108 and the second gate electrode 118 may include the same material(s). In some embodiments, the first gate electrode 108 and the second gate electrode 118 may be integrally formed (united) to constitute a gate electrode of the integrated circuit device 10.

In some embodiments, the second channel layers 112 may include semiconductor material(s), for example, Si, Ge, SiGe, GaP, GaAs, SiC, SiGeC and/or InP. In some embodiments, the second gate insulators 114 may include insulator(s), for example, silicon oxide, silicon oxynitride, silicon nitride, silicon carbonitride and/or a low-k material that has a lower dielectric constant than that of silicon oxide. In some embodiments, the second work function layers 116 may include, for example, a TiN layer, a TaN layer, a TiAl layer, a TiC layer, a TiAlC layer, a TiAlN layer and/or a WN layer. In some embodiments, the second gate electrode 118 may include, for example, tungsten (W), aluminum (Al) and/or copper (Cu). However, the materials in the second channel layers 112, the second gate insulators 114, the second work function layers 116, and the second gate electrode 118 are not limited to the embodiments described above.

The second gate electrode 118 may comprise a second inner gate electrode 118_I and a second outer gate electrode 118_O. The second inner gate electrode 118_I may be between adjacent ones of the second channel layers 112 in the vertical direction. The second outer gate electrode 118_O may be on an upper surface of the uppermost one of the second channel layers 112 and/or on a lower surface of the lowermost one of the second channel layers 112. The second outer gate electrode 118_O may be between the lowermost one of the second channel layers 112 and the first insulator 110 in the vertical direction. In some embodiments, the second inner gate electrode 118_I and the second outer gate electrode 118_O may be integrally formed (united) to constitute the second gate electrode 118.

In some embodiments, the thickness of the second gate structure between adjacent ones of the second channel layers 112 in the vertical direction and a thickness of the second gate structure between the lowermost one of the second channel layers 112 and the first insulator 110 (which will be described in detail later) in the vertical direction may be equal or substantially equal. For example, a thickness of the second inner gate electrode 118_I in the vertical direction may be equal or substantially equal to a thickness of the second outer gate electrode 118_O, which is between the lowermost one of the second channel layers 112 and the first insulator 110, in the vertical direction.

In some embodiments, each of the first channel layers 102 and the second channel layers 112 may be a nanosheet (that may have a thickness in a range of from about 1 nm to about 100 nm in the vertical direction) or may be a nanowire (that may have a circular cross-section with a diameter in a range of from about 1 nm to about 100 nm). In some embodiments, each of the first channel layers 102 and each of the second channel layers 112 may have an equal thickness in the vertical direction.

The integrated circuit device 10 may include the first insulator 110 (e.g., the inter-gate insulator 110 or the middle dielectric isolation 110) between the first transistor 140 and the second transistor 160 in the vertical direction. A width of the first insulator 110 in the horizontal direction may be equal or substantially equal to the width of the uppermost one of the first channel layers 102 in the horizontal direction. In some embodiments, side surfaces of the first insulator 110 may be aligned with corresponding side surfaces of the uppermost one of the first channel layers 102, respectively. For example, the first insulator 110 may have the first width W1 in the horizontal direction. In some embodiments, the width of the first insulator 110 in the horizontal direction may be equal or substantially equal to the width of each of the first channel layers 102 in the horizontal direction. The first insulator 110 may have multiple (e.g., non-uniform) thicknesses in the vertical direction. For example, the first insulator 110 may have a first portion having a first thickness in the vertical direction and a second portion having a second thickness in the vertical direction, and the second thickness is greater than the first thickness. In some embodiments, a portion of the first insulator 110 may be recessed to have a thickness (e.g., the first thickness) in the vertical direction that is less than that of (e.g., the second thickness) another portion of the first insulator 110. The recess of the first insulator 110 may be toward the uppermost one of the first channel layers 102. For example, in a cross-sectional view, the first insulator 110 may have a step shape that is asymmetrical in the horizontal direction. The step shape of the first insulator 110 may comprise an oblique curve. However, the shape of the first insulator 110 is not limited thereto. The first insulator 110 may include insulator(s), for example, silicon nitride (e.g., SiN). However, the material of the first insulator 110 is not limited thereto.

Although FIG. 1 illustrates that the first transistor 140 includes three first channel layers 102, in some embodiments, the first transistor 140 may include one, two or more than three first channel layers 102. Although FIG. 1 illustrates that the second transistor 160 includes three second channel layers 112, in some embodiments, the second transistor 160 may include one, two or more than three second channel layers 112.

Although not shown in FIGS. 1, the integrated circuit device 10 may also include a middle-of-line (MOL) structure and a back-end-of-line (BEOL) structure. Each of the MOL and BEOL structures may include interlayer insulating layer(s) in which conductive wire(s) (e.g., metal wire(s)) and conductive via plug(s) (e.g., metal via plug(s)) are provided. Various elements of the first transistor 140 and the second transistor 160 may be (electrically) connected to one of the conductive wires of the MOL and BEOL structures.

Further, in some embodiments, a backside power distribution network structure (BSPDNS) may be provided below or within the substrate 100. In some embodiments, some elements of the BSPDNS may be provided in the substrate 100. The BSPDNS may include backside insulating layer(s) in which conductive backside wire(s) (e.g., metal power rail(s)) and conductive backside contact(s) (e.g., backside metal contact(s)) are provided. Various elements of the first transistor 140 and the second transistor 160 may be (electrically) connected to one of the conductive backside wires.

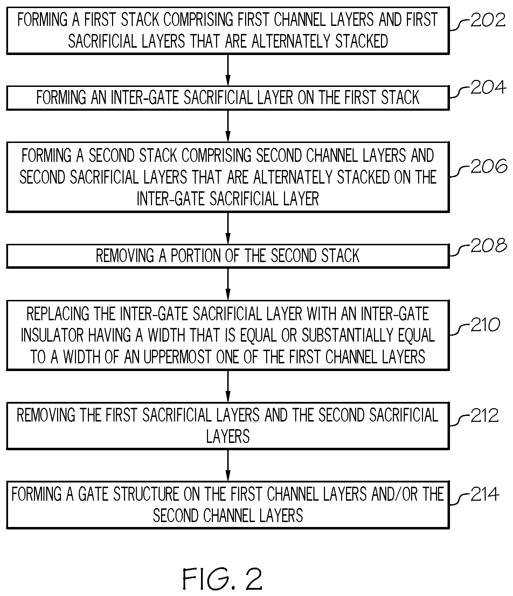

FIG. 2 is a flowchart of methods of forming an integrated circuit device according to some embodiments. For example, FIG. 2 is a flowchart of methods of forming the integrated circuit device 10 according to some embodiments illustrated in FIG. 1.

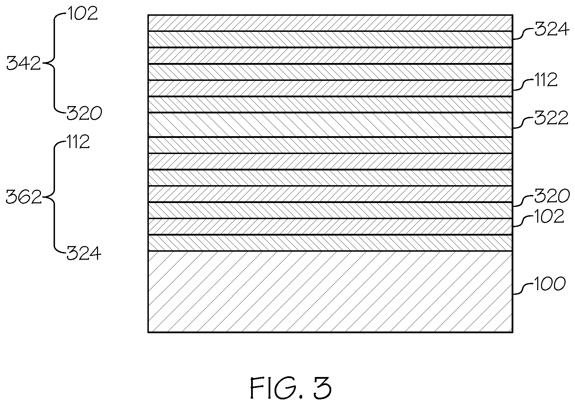

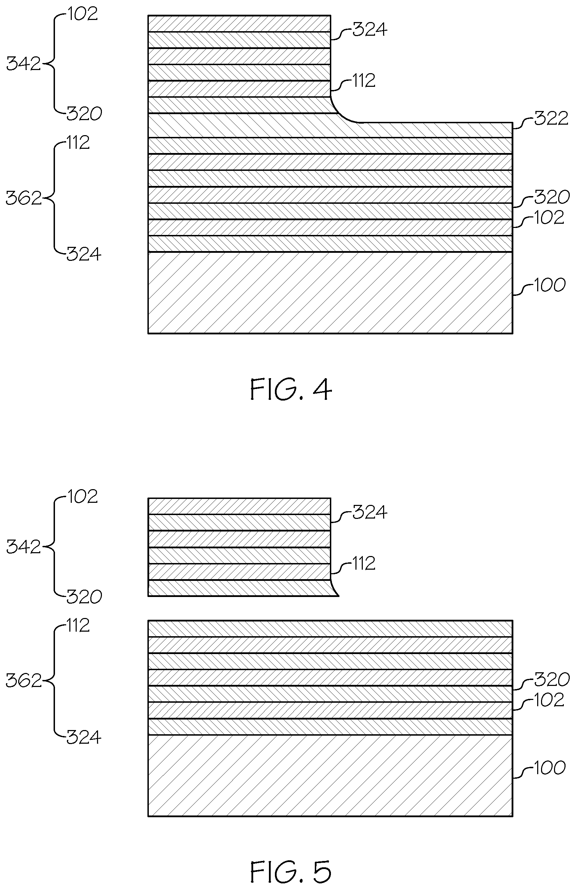

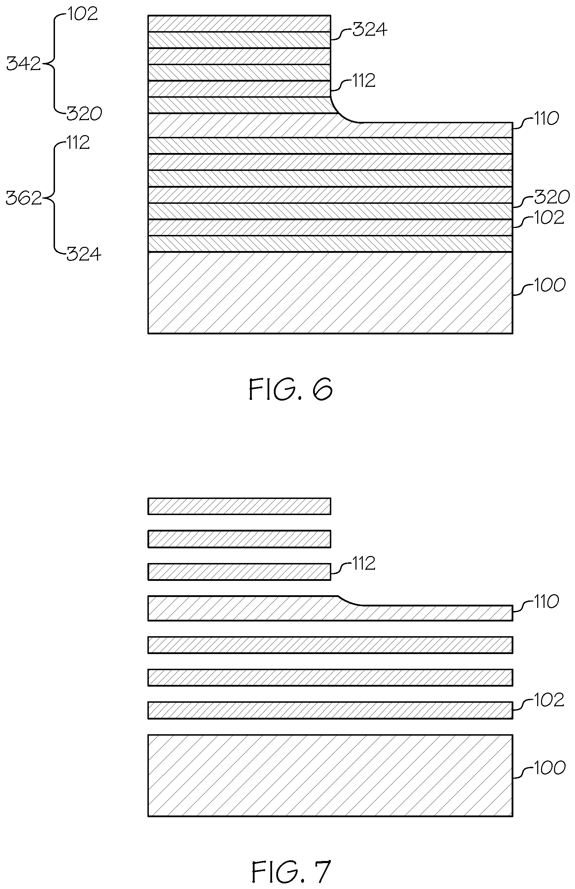

FIGS. 3 through 7 are cross-sectional views illustrating methods of forming an integrated circuit device according to some embodiments. For example, FIGS. 3 through 7 are cross-sectional views illustrating methods of forming the integrated circuit device 10 according to some embodiments illustrated in FIG. 1.

Referring to FIGS. 1, 2, and 3, the method may include forming a first stack 342 (e.g., a lower stack 342) on the substrate 100 (Block 202). The first stack 342 may comprise the first channel layers 102 and first sacrificial layers 320 (e.g., lower sacrificial layers 320). In some embodiments, the first channel layers 102 and the first sacrificial layers 320 may be alternately stacked in the vertical direction. In some embodiments, the first sacrificial layers 320 may include a material having an etch selectivity with respect to the first channel layers 102. For example, the first sacrificial layers 320 may include SiGe.

Referring to FIGS. 1, 2, and 3, an inter-gate sacrificial layer 322 (also referred to as a middle sacrificial layer 322) may be formed on the first stack 342 (Block 204). The first stack 342 may be between the inter-gate sacrificial layer 322 and the substrate 100 in the vertical direction.

Referring to FIGS. 1, 2, and 3, a second stack 362 (e.g., an upper stack 362) may be formed on the inter-gate sacrificial layer 322 (Block 206). The inter-gate sacrificial layer 322 may be between the first stack 342 and the second stack 362 in the vertical direction. The second stack 362 may include the second channel layers 112 and second sacrificial layers 324 (e.g., upper sacrificial layers 324). In some embodiments, the second channel layers 112 and the second sacrificial layers 324 may be alternately stacked in the vertical direction. In some embodiments, the second sacrificial layers 324 may include a material having an etch selectivity with respect to the second channel layers 112. For example, the second sacrificial layers 324 may include SiGe.

In some embodiments, the inter-gate sacrificial layer 322 may include a material having an etch selectivity with respect to the first channel layers 102, the first sacrificial layers 320, the second channel layers 112, and the second sacrificial layers 324. For example, the inter-gate sacrificial layer 322 may include SiGe with a different Ge concentration from SiGe of the first sacrificial layers 320 and the second sacrificial layers 324. However, the materials of the first sacrificial layers 320, the second sacrificial layers 324, and the inter-gate sacrificial layer 322 are not limited to the embodiments described above.

Referring to FIGS. 1, 2, and 4, a portion of the second stack 362 may be removed (e.g., etched) to expose a portion of the inter-gate sacrificial layer 322 (Block 208). In some embodiments, a portion of the inter-gate sacrificial layer 322 may be removed along with the portion of the second stack 362. In some embodiments, the inter-gate sacrificial layer 322 may have multiple thicknesses in the vertical direction after removing the portion of the inter-gate sacrificial layer 322. For example, a portion of the inter-gate sacrificial layer 322 may be recessed (e.g., etched or damaged) to have a thickness (e.g., a first thickness) in the vertical direction that is less than that of (e.g., the second thickness) another portion of the inter-gate sacrificial layer 322. For example, in a cross-sectional view, the inter-gate sacrificial layer 322 may have a step shape that is asymmetrical in the horizontal direction. The step shape of the inter-gate sacrificial layer 322 may comprise an oblique curve. However, the shape of the inter-gate sacrificial layer 322 is not limited thereto.

Referring to FIGS. 1, 2, 5, and 6, the inter-gate sacrificial layer 322 may be removed, and the first insulator 110 (e.g., the inter-gate insulator 110 or the middle dielectric isolation 110) may be formed in the space from which the inter-gate sacrificial layer 322 has been removed. In some embodiments, the inter-gate sacrificial layer 322 may be replaced with the first insulator 110. (Block 210). For example, as the inter-gate sacrificial layer 322 may have an etch selectivity with respect to the first channel layers 102, the first sacrificial layers 320, the second channel layers 112, and the second sacrificial layers 324, the inter-gate sacrificial layer 322 may be selectively etched while not etching the first stack 342 and the second stack 362. Then, the first insulator 110 may be formed in the space from which the inter-gate sacrificial layer 322 has been etched. The shape of the first insulator 110 may be the same or substantially the same as the shape of the inter-gate sacrificial layer 322.

Referring to FIGS. 1, 2, and 7, the first sacrificial layers 320 and the second sacrificial layers 324 may be removed (Block 212).

Referring to FIGS. 1 and 2, a gate structure may be formed on the first channel layers 102 and the second channel layers 112 (Block 214). In some embodiments, the gate structure may be formed on the first insulator 110. In some embodiments, the gate structure may include the first gate structure comprising, the first gate insulator 104, the first work function layers 106, and the first gate electrode 108 formed on the first channel layers 102, and the second gate structure comprising the second gate insulator 114, the second work function layers 116, and the second gate electrode 118 formed on the second channel layers 112.

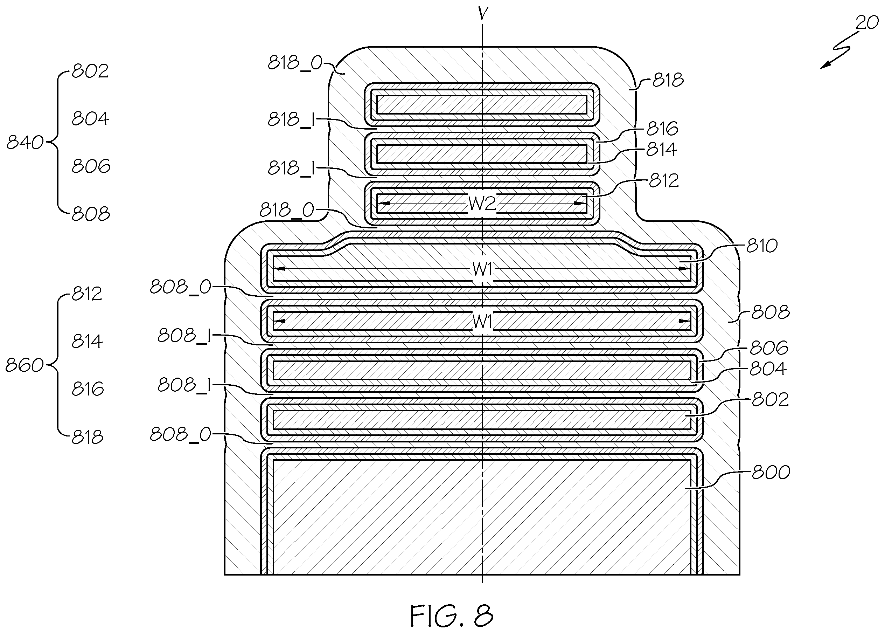

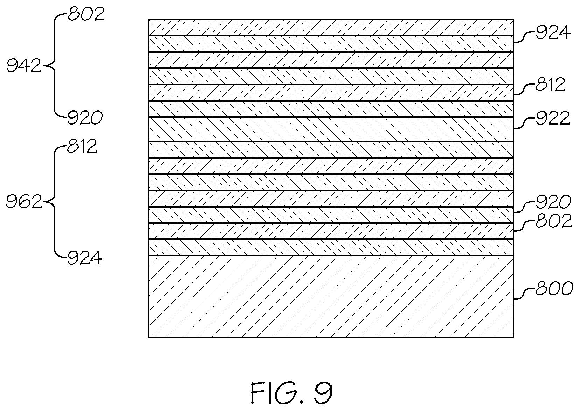

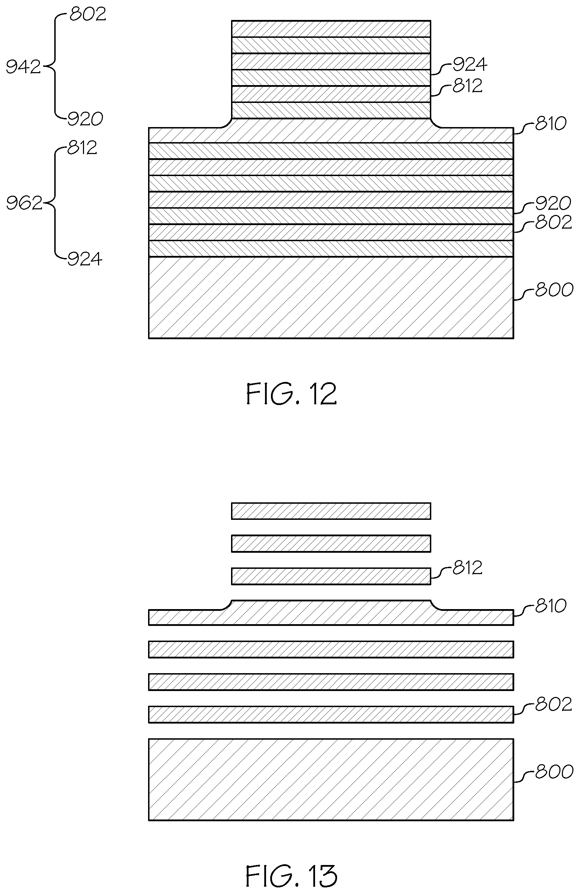

FIG. 8 is a cross-sectional view of an integrated circuit device 20 according to some embodiments. FIGS. 9 through 13 are cross-sectional views illustrating methods of forming the integrated circuit device 20 in FIG. 8 according to some embodiments. Since the integrated circuit device 20 may be formed and configured similarly as the integrated circuit device 10 in FIG. 1, detailed descriptions of the common configuration and common manufacturing method with the integrated circuit device 10 may be omitted, and differences from the integrated circuit device 10 will be described in detail. The substrate 800, the first channel layers 802, the first gate insulators 804, the first work function layers 806, the first gate electrode 808, the first insulator 810, the second channel layers 812, the second gate insulators 814, the second work function layers 816, the second gate electrode 818, the first sacrificial layers 920, the inter-gate sacrificial layer 922, the second sacrificial layers 924, the first transistor 840, the second transistor 860, the first stack 942, and the second stack 962 may correspond to the substrate 100, the first channel layers 102, the first gate insulators 104, the first work function layers 106, the first gate electrode 108, the first insulator 110, the second channel layers 112, the second gate insulators 114, the second work function layers 116, the second gate electrode 118, the first sacrificial layers 320, the inter-gate sacrificial layer 322, the second sacrificial layers 324, the first transistor 140, the second transistor 160, the first stack 342, and the second stack 362, respectively. The description of FIGS. 8, 9, 10, 11, 12, and 13 may correspond to FIGS. 1, 3, 4, 5, 6, and 7, respectively.

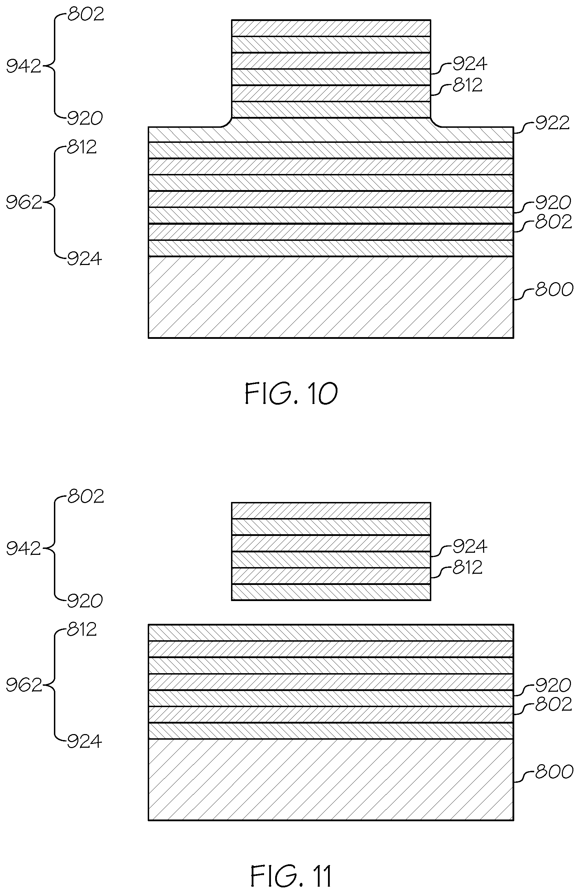

According to FIG. 8, unlike FIG. 1, the first insulator 810 may have a symmetrical shape in the horizontal direction. In some embodiments, in a cross-sectional view, the first insulator 810 may have two step shapes mirror-imaged to each other in the horizontal direction. For example, the first insulator 810 may have a mirror-image with respect to an imaginary vertical line V at the center of the first insulator 810. Such symmetrical shape of the first insulator 810 may be a result of a symmetrical removal of a portion(s) of the inter-gate sacrificial layer 922 illustrated in FIG. 10.

According to the integrated circuit device 20 in FIG. 8, unlike the integrated circuit device 10 in FIG. 1, the center of the first transistor 840 and the center of the second transistor 860 may be aligned or substantially aligned with each other in the vertical direction.

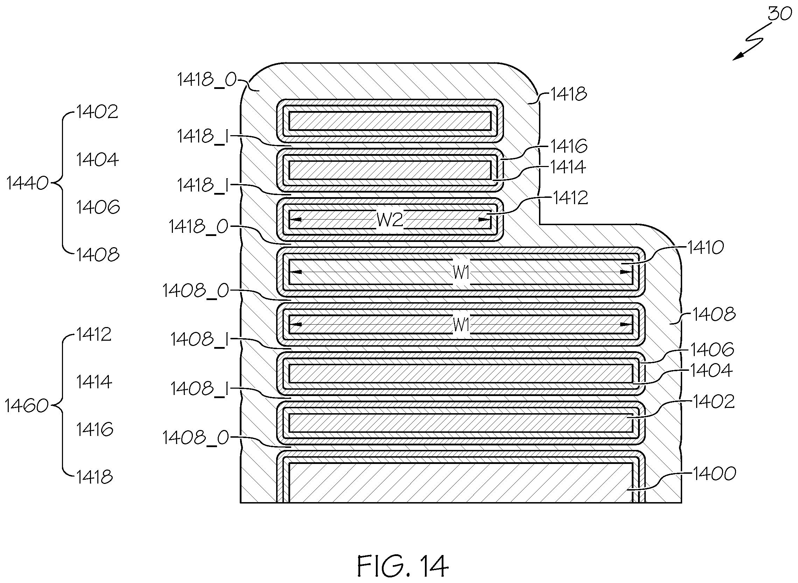

FIG. 14 is a cross-sectional view of an integrated circuit device 30 according to some embodiments. Since the integrated circuit device 30 may be configured similarly as the integrated circuit device 10 in FIG. 1, detailed descriptions of the common configuration with the integrated circuit device 10 may be omitted, and differences from the integrated circuit device 10 will be described in detail. The substrate 1400, the first channel layers 1402, the first gate insulators 1404, the first work function layers 1406, the first gate electrode 1408, the first insulator 1410, the second channel layers 1412, the second gate insulators 1414, the second work function layers 1416, the second gate electrode 1418, the first transistor 1440, and the second transistor 1460 may correspond to the substrate 100, the first channel layers 102, the first gate insulators 104, the first work function layers 106, the first gate electrode 108, the first insulator 110, the second channel layers 112, the second gate insulators 114, the second work function layers 116, the second gate electrode 118, the first transistor 140, and the second transistor 160, respectively.

According to the integrated circuit device 30 in FIG. 14, unlike the integrated circuit device 10 in FIG. 1, the first insulator 1410 may have a uniform or a substantially uniform thickness in the vertical direction.

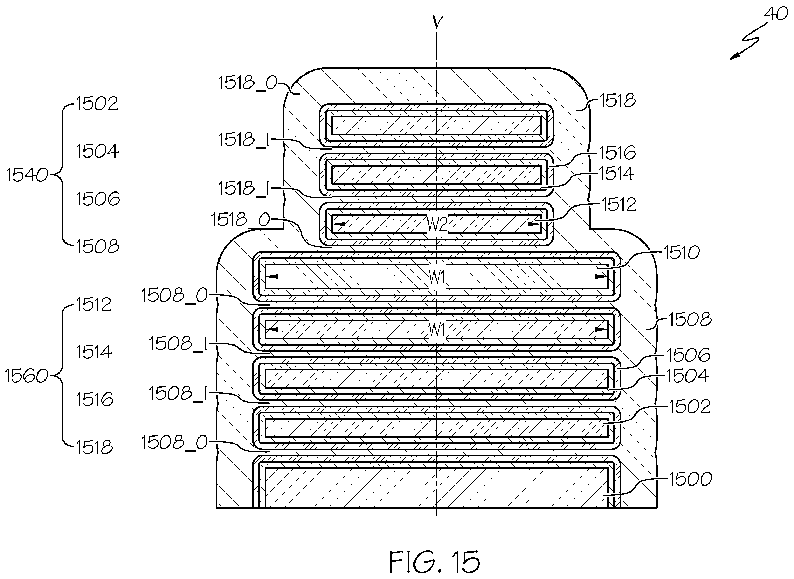

FIG. 15 is a cross-sectional view of an integrated circuit device 40 according to some embodiments. Since the integrated circuit device 40 may be configured similarly as the integrated circuit device 20 in FIG. 8, detailed descriptions of the common configuration with the integrated circuit device 20 may be omitted, and differences from the integrated circuit device 20 will be described in detail. The substrate 1500, the first channel layers 1502, the first gate insulators 1504, the first work function layers 1506, the first gate electrode 1508, the first insulator 1510, the second channel layers 1512, the second gate insulators 1514, the second work function layers 1516, the second gate electrode 1518, the first transistor 1540, and the second transistor 1560 may correspond to the substrate 800, the first channel layers 802, the first gate insulators 804, the first work function layers 806, the first gate electrode 808, the first insulator 810, the second channel layers 812, the second gate insulators 814, the second work function layers 816, the second gate electrode 818, the first transistor 840, and the second transistor 860, respectively.

According to the integrated circuit device 40 in FIG. 15, unlike the integrated circuit device 20 in FIG. 8, the first insulator 1510 may have a uniform or a substantially uniform thickness in the vertical direction.

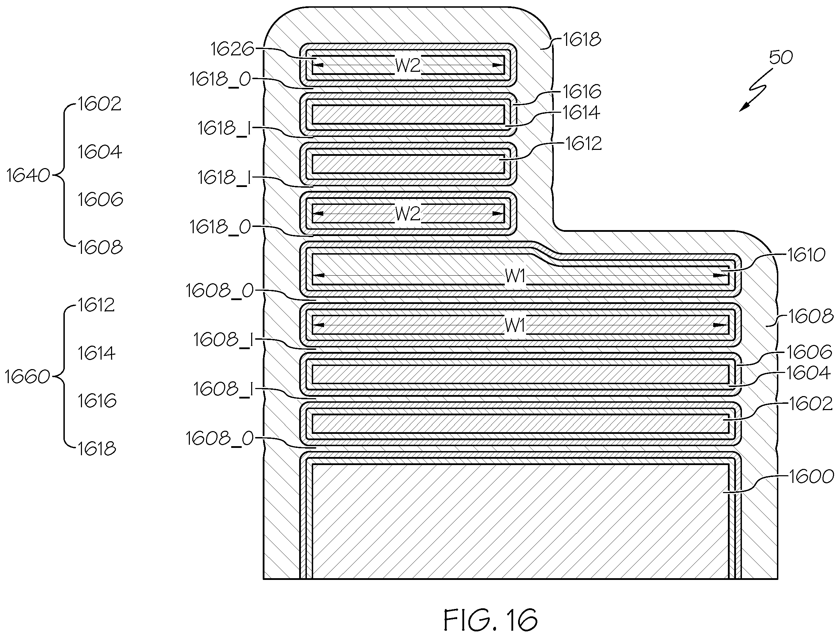

FIG. 16 is a cross-sectional view of an integrated circuit device 50 according to some embodiments. Since the integrated circuit device 50 may be configured similarly as the integrated circuit device 10 in FIG. 1, detailed descriptions of the common configuration with the integrated circuit device 10 may be omitted, and differences from the integrated circuit device 10 will be described in detail. The substrate 1600, the first channel layers 1602, the first gate insulators 1604, the first work function layers 1606, the first gate electrode 1608, the first insulator 1610, the second channel layers 1612, the second gate insulators 1614, the second work function layers 1616, the second gate electrode 1618, the first transistor 1640, and the second transistor 1660 may correspond to the substrate 100, the first channel layers 102, the first gate insulators 104, the first work function layers 106, the first gate electrode 108, the first insulator 110, the second channel layers 112, the second gate insulators 114, the second work function layers 116, the second gate electrode 118, the first transistor 140, and the second transistor 160, respectively.

The integrated circuit device 50 may further include a second insulator 1626 (also referred to as an upper insulator 1626) on the second transistor 1660. For example, the second insulator 1626 may be on the second channel layers 1612. The second transistor 1660 may be between the first insulator 1610 and the second insulator 1626 in the vertical direction.

In some embodiments, the second gate electrode 1618 may comprise a second inner gate electrode 1618_I and a second outer gate electrode 1618_O. The second inner gate electrode 1618_I may be between adjacent ones of the second channel layers 1612 in the vertical direction. The second outer gate electrode 1618_O may be between the uppermost one of the second channel layers 1612 and the second insulator 1626 in the vertical direction and/or between the lowermost one of the second channel layers 1612 and the first insulator 1610 in the vertical direction.

In some embodiments, the thickness of the second gate structure between adjacent ones of the second channel layers 1612 in the vertical direction and a thickness of the second gate structure between the uppermost one of the second channel layers 1612 and the second insulator 1626 in the vertical direction may be equal or substantially equal. In some embodiments, the thickness of the second gate structure between adjacent ones of the second channel layers 1612 in the vertical direction and a thickness of the second gate structure between the lowermost one of the second channel layers 1612 and the first insulator 1610 in the vertical direction may be equal or substantially equal. For example, a thickness of the second inner gate electrode 1618_I in the vertical direction may be equal or substantially equal to a thickness of the second outer gate electrode 1618_O in the vertical direction.

A width of the second insulator 1626 in the horizontal direction may be equal or substantially equal to the width of the uppermost one of the second channel layers 1612 in the horizontal direction. In some embodiments, side surfaces of the second insulator 1626 may be aligned with corresponding side surfaces of the uppermost one of the second channel layers 1612, respectively. For example, the second insulator 1626 may have the second width W2 in the horizontal direction. In some embodiments, the width of the second insulator 1626 in the horizontal direction may be equal or substantially equal to the width of each of the second channel layers 1612 in the horizontal direction. The second insulator 1626 may have a uniform or a substantially uniform thickness in the vertical direction. However, the shape of the second insulator 1626 is not limited thereto. The second insulator 1626 may include insulator(s), for example, silicon nitride (e.g., SiN). However, the material of the second insulator 1626 is not limited thereto.

As the thickness of the second inner gate electrode 1618_I in the vertical direction is equal or substantially equal to the thickness of the second outer gate electrode 1618_O in the vertical direction by forming the width of the second insulator 1626 in the horizontal direction equal or substantially equal to the width of the uppermost one of the second channel layers 1612 in the horizontal direction, the performance of the integrated circuit device 50 (e.g., the second transistor 1660) may be improved. For example, the sub-threshold swing and/or the hump in the I-V curve of the integrated circuit device 50 (e.g., the second transistor 1660) may be improved (e.g., reduced) as the thickness of the second inner gate electrode 1618_I in the vertical direction is equal or substantially equal to the thickness of the second outer gate electrode 1618_O in the vertical direction.

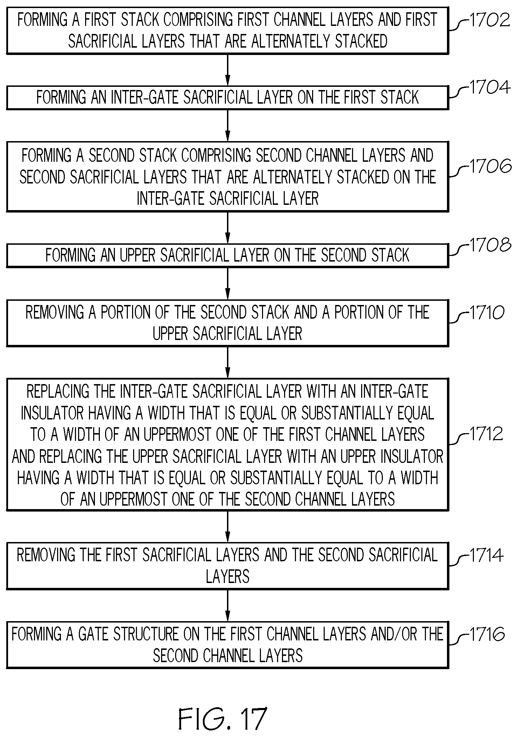

FIG. 17 is a flowchart of methods of forming an integrated circuit device according to some embodiments. For example, FIG. 17 is a flowchart of methods of forming the integrated circuit device 50 according to some embodiments illustrated in FIG. 16.

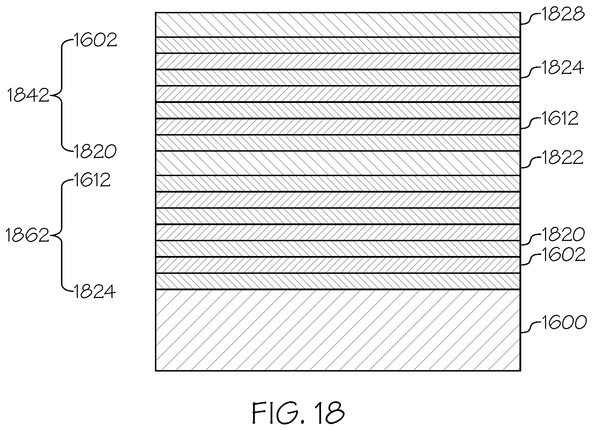

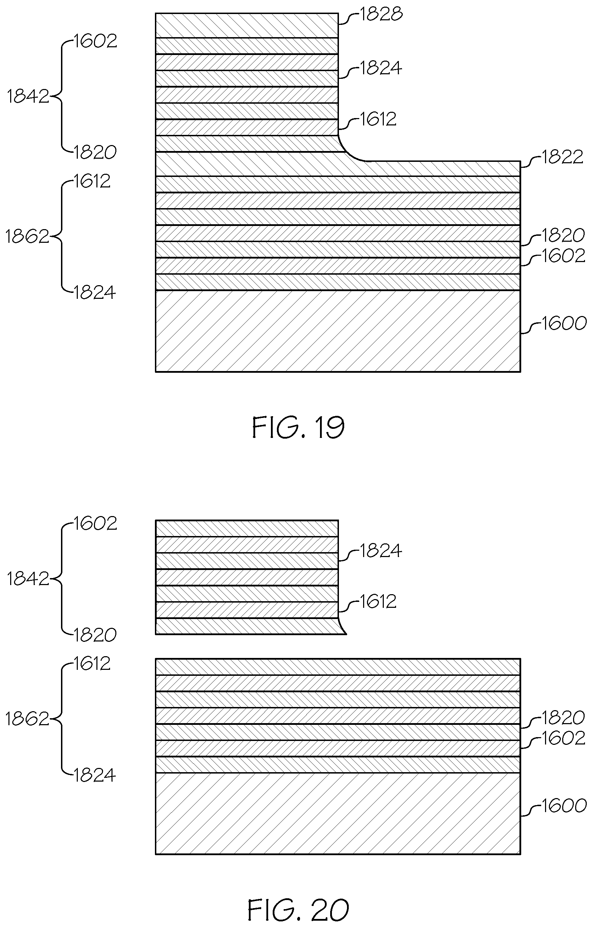

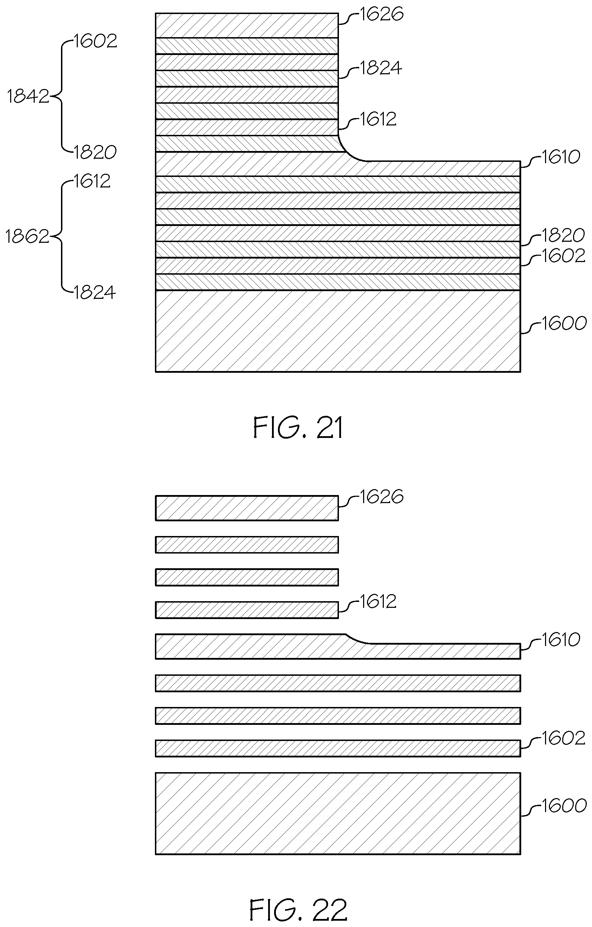

FIGS. 18 through 22 are cross-sectional views illustrating methods of forming an integrated circuit device according to some embodiments. For example, FIGS. 18 through 22 are cross-sectional views illustrating methods of forming the integrated circuit device 50 according to some embodiments illustrated in FIG. 16.

Referring to FIGS. 16, 17, and 18, the method may include forming a first stack 1842 (e.g., a lower stack 1842) on the substrate 1600 (Block 1702). The first stack 1842 may include the first channel layers 1602 (e.g., lower channel layers 1602) and first sacrificial layers 1820 (e.g., lower sacrificial layers 1820). In some embodiments, the first channel layers 1602 and the first sacrificial layers 1820 may be alternately stacked in the vertical direction. In some embodiments, the first sacrificial layers 1820 may include a material having an etch selectivity with respect to the first channel layers 1602. For example, the first sacrificial layers 1820 may include SiGe.

Referring to FIGS. 16, 17, and 18, an inter-gate sacrificial layer 1822 (also referred to as a middle sacrificial layer 1822) may be formed on the first stack 1842 (Block 1704). The first stack 1842 may be between the inter-gate sacrificial layer 1822 and the substrate 1600 in the vertical direction.

Referring to FIGS. 16, 17, and 18, a second stack 1862 (e.g., an upper stack 1862) may be formed on the inter-gate sacrificial layer 1822 (Block 1706). The inter-gate sacrificial layer 1822 may be between the first stack 1842 and the second stack 1862 in the vertical direction. The second stack 1862 may include the second channel layers 1612 and second sacrificial layers 1824 (e.g., upper sacrificial layers 1824). In some embodiments, the second channel layers 1612 and the second sacrificial layers 1824 may be alternately stacked in the vertical direction. In some embodiments, the second sacrificial layers 1824 may include a material having an etch selectivity with respect to the second channel layers 1612. For example, the second sacrificial layers 1824 may include SiGe.

Referring to FIGS. 16, 17, and 18, an upper sacrificial layer 1828 may be formed on the second stack 1862 (Block 1708). The second stack 1862 may be between the inter-gate sacrificial layer 1822 and the upper sacrificial layer 1828 in the vertical direction. In some embodiments, each of the inter-gate sacrificial layer 1822 and the upper sacrificial layer 1828 may include a material having an etch selectivity with respect to the first channel layers 1602, the first sacrificial layers 1820, the second channel layers 1612, and the second sacrificial layers 1824. For example, each of the inter-gate sacrificial layer 1822 and the upper sacrificial layer 1828 may include SiGe with a different Ge concentration from SiGe of the first sacrificial layers 1820 and the second sacrificial layers 1824. However, the materials of the first sacrificial layers 1820, the second sacrificial layers 1824, the inter-gate sacrificial layer 1822, and the upper sacrificial layer 1828 are not limited to the embodiments described above.

Referring to FIGS. 16, 17, and 19, a portion of the second stack 1862 and a portion of the upper sacrificial layer 1828 may be removed (e.g., etched) to expose a portion of the inter-gate sacrificial layer 1822 (Block 1710). In some embodiments, a portion of the inter-gate sacrificial layer 1822 may be removed along with the portion of the second stack 1862 and the portion of the upper sacrificial layer 1828. In some embodiments, the inter-gate sacrificial layer 1822 may have multiple thicknesses in the vertical direction after removing the portion of the inter-gate sacrificial layer 1822. For example, a portion of the inter-gate sacrificial layer 1822 may be recessed (e.g., etched or damaged) to have a thickness (e.g., a first thickness) in the vertical direction that is less than that of (e.g., the second thickness) another portion of the inter-gate sacrificial layer 1822. For example, in a cross-sectional view, the inter-gate sacrificial layer 1822 may have a step shape that is asymmetrical in the horizontal direction. The step shape of the inter-gate sacrificial layer 1822 may comprise an oblique curve. However, the shape of the inter-gate sacrificial layer 1822 is not limited thereto. In some embodiments, the remaining portion of the upper sacrificial layer 1828 may have a uniform or a substantially uniform thickness in the vertical direction after the removal of the portion of the upper sacrificial layer 1828.

Referring to FIGS. 16, 17, 20, and 21, the inter-gate sacrificial layer 1822 and the upper sacrificial layer 1828 may be removed, and the first insulator 1610 (e.g., the inter-gate insulator 1610 or the middle dielectric isolation 1610) and the second insulator 1626 (e.g., the upper insulator 1626) may be formed in the spaces from which the inter-gate sacrificial layer 1822 and the upper sacrificial layer 1828 have been removed, respectively. In some embodiments, the inter-gate sacrificial layer 1822 may be replaced with the first insulator 1610, and the upper sacrificial layer 1828 may be replaced with the second insulator 1626. (Block 1712). For example, as the inter-gate sacrificial layer 1822 may have an etch selectivity with respect to the first channel layers 1602, the first sacrificial layers 1820, the second channel layers 1612, and the second sacrificial layers 1824, the inter-gate sacrificial layer 1822 may be selectively etched while not etching the first stack 1842 and the second stack 1862. Then, the first insulator 1610 may be formed in the space from which the inter-gate sacrificial layer 1822 has been etched. The shape of the first insulator 1610 may be the same or substantially the same as the shape of the inter-gate sacrificial layer 1822.

Referring to FIGS. 16, 17, and 22, the first sacrificial layers 1820 and the second sacrificial layers 1824 may be removed (Block 1714).

Referring to FIGS. 16 and 17, a gate structure may be formed on the first channel layers 1602 and/or the second channel layers 1612 (Block 1716). In some embodiments, the gate structure may be further formed on the first insulator 1610 and the second insulator 1626. In some embodiments, the gate structure may include the first gate structure comprising the first gate insulators 1604, the first work function layers 1606, and the first gate electrode 1608 formed on the first channel layers 1602, and the second gate structure comprising the second gate insulators 1614, the second work function layers 1616 and the second gate electrode 1618 formed on the second channel layers 1612.

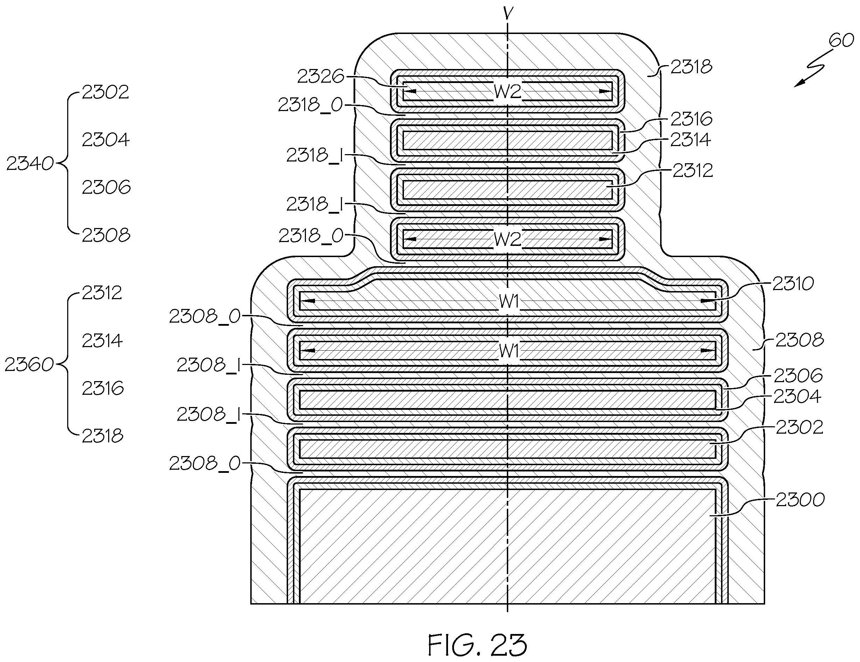

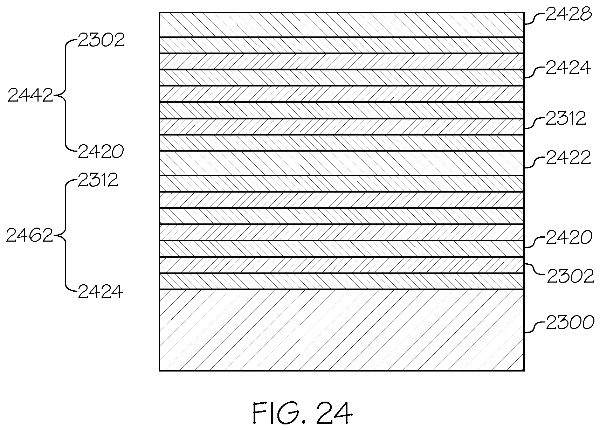

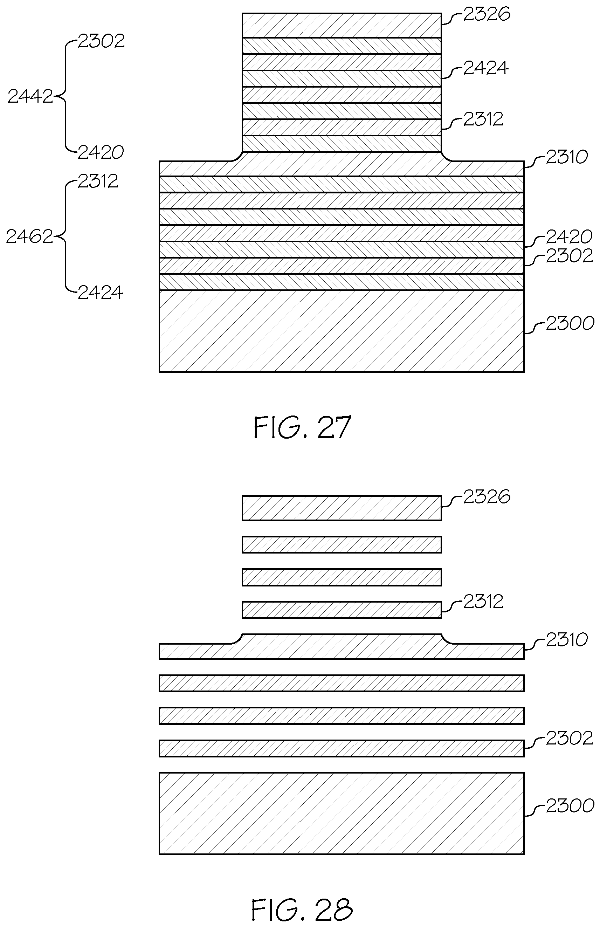

FIG. 23 is a cross-sectional view of an integrated circuit device 60 according to some embodiments. FIGS. 24 through 28 are cross-sectional views illustrating methods of forming an integrated circuit device 60 in FIG. 23 according to some embodiments. Since the integrated circuit device 60 may be formed and configured similarly as the integrated circuit device 50 in FIG. 16, detailed descriptions of the common configuration and common manufacturing method with the integrated circuit device 50 may be omitted, and differences from the integrated circuit device 50 will be described in detail. The substrate 2300, the first channel layers 2302, the first gate insulators 2304, the first work function layers 2306, the first gate electrode 2308, the first insulator 2310, the second channel layers 2312, the second gate insulators 2314, the second work function layers 2316, the second gate electrode 2318, the second insulator 2326, the first sacrificial layers 2420, the inter-gate sacrificial layer 2422, the second sacrificial layers 2424, the upper sacrificial layer 2428, the first transistor 2340, the second transistor 2360, the first stack 2442, and the second stack 2462 may correspond to the substrate 1600, the first channel layers 1602, the first gate insulators 1604, the first work function layers 1606, the first gate electrode 1608, the first insulator 1610, the second channel layers 1612, the second gate insulators 1614, the second work function layers 1616, the second gate electrode 1618, the second insulator 1626, the first sacrificial layers 1820, the inter-gate sacrificial layer 1822, the second sacrificial layers 1824, the upper sacrificial layer 1828, the first transistor 1640, the second transistor 1660, the first stack 1842, and the second stack 1862, respectively. The description of FIGS. 16, 18, 19, 20, 21, and 22 may correspond to FIGS. 23, 24, 25, 26, 27, and 28, respectively.

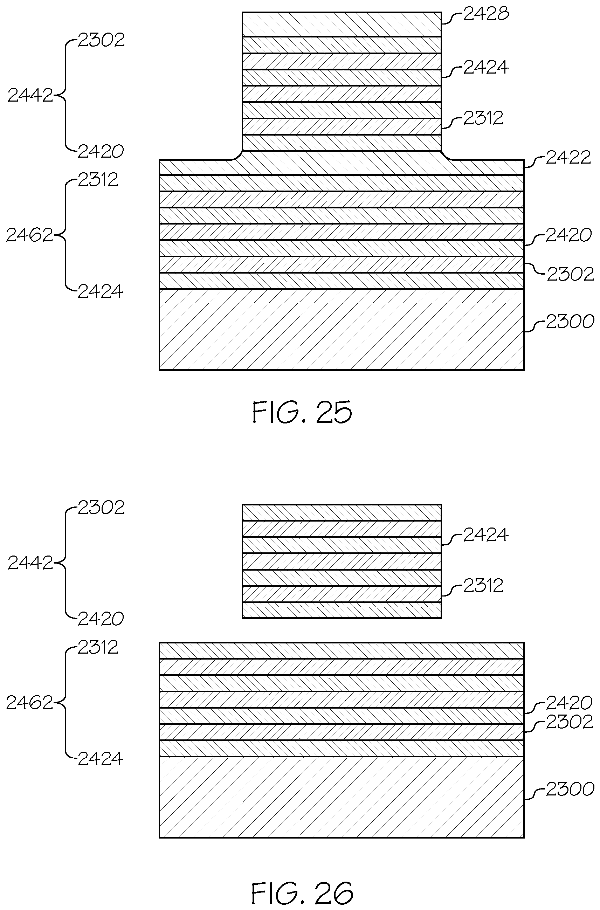

According to FIG. 23, unlike FIG. 16, the first insulator 2310 may have a symmetrical shape in the horizontal direction. For example, in a cross-sectional view, the first insulator 2310 may have two step shapes mirror-imaged to each other in the horizontal direction. Such symmetrical shape of the first insulator 2310 may be a result of a symmetrical removal of a portion(s) of the inter-gate sacrificial layer 2422 illustrated in FIG. 25.

According to the integrated circuit device 60 in FIG. 23, unlike the integrated circuit device 50 in FIG. 16, the center of the first transistor 2340 and the center of the second transistor 2360 may be aligned or substantially aligned with each other in the vertical direction.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present inventive concepts to those skilled in the art. In the drawings, the sizes and relative sizes of layers and regions may be exaggerated for clarity. Like reference numbers may refer to like elements throughout unless clearly stated otherwise.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present inventive concepts.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

As used herein, "an element A overlapping an element B in a direction X" (or similar language) means that there is at least one line that extends in the direction X and intersects both the elements A and B.

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

As used herein, "a lower surface" refers to a surface facing a substrate (e.g., the substrate 100 in FIG. 1), and "an upper surface" refers to a surface opposite the lower surface. Further, as used herein, "a lower portion" refers to a portion that is closer than "an upper portion" to the substrate.

Many different embodiments have been disclosed herein, in connection with the above description and the drawings. It will be understood that it would be unduly repetitious and obfuscating to literally describe and illustrate every combination and sub-combination of these embodiments. Accordingly, the present specification, including the drawings, shall be construed to constitute a complete written description of all combinations and sub-combinations of the embodiments described herein, and of the manner and process of making and using them, and shall support claims to any such combination or sub-combination.

The above-disclosed subject matter is to be considered illustrative, and not restrictive, and the appended claims are intended to cover all such modifications, enhancements, and other embodiments, which fall within the scope of the present inventive concepts. Thus, to the maximum extent allowed by law, the scope is to be determined by the broadest permissible interpretation of the following claims and their equivalents, and shall not be restricted or limited by the foregoing detailed description.

It is noted that embodiments described herein may use different reference signs for a same or similar element. Although multiple of the embodiments described herein may fall within the scope of a given claim, only a representative subset of the reference signs has been included in the claim for reasons of readability and conciseness.

## Claims

1. An integrated circuit device comprising:
a substrate (100);
an insulator (110) on an upper surface of the substrate (100);
a transistor (140) between the substrate (100) and the insulator (110), the transistor (140) comprising:
channel layers (102) that are spaced apart from each other in a first direction that is perpendicular to the upper surface of the substrate (100); and
a gate structure (104, 106, 108) on the channel layers (102) and the insulator (110),
wherein a width (W1) of the insulator (110) in a second direction that is parallel with the upper surface of the substrate (100) is equal or substantially equal to a width (W1) of an uppermost one of the channel layers (102) in the second direction.

2. The integrated circuit device of claim 1, wherein a distance between the insulator (110) and the uppermost one of the channel layers (102) in the first direction is equal or substantially equal to a distance between adjacent ones of the channel layers (102) in the first direction.

3. The integrated circuit device of claim 1 or 2, wherein a first portion (108_O) of the gate structure (104, 106, 108) between the insulator (110) and the uppermost one of the channel layers (102) and a second portion (108_1) of the gate structure (104, 106, 108) between the adjacent ones of the channel layers (102) have an equal or a substantially equal thickness in the first direction.

4. The integrated circuit device of any one of claims 1 to 3, wherein each of the channel layers (102) has an equal or a substantially equal width (W1) in the second direction.

5. The integrated circuit device of any one of claims 1 to 4, wherein the insulator (110) has a first portion having a first thickness in the first direction and a second portion having a second thickness in the first direction, the second thickness being different from the first thickness, and/or
wherein the insulator (110) comprises a recess that is toward the uppermost one of the first channel layers (102).

6. The integrated circuit device of any one of claims 1 to 5, wherein the insulator (110; 810) has an asymmetrical shape in a cross-sectional view or a symmetrical shape in a cross-sectional view.

7. The integrated circuit device of any one of claims 1 to 6, wherein the transistor (140) is a first transistor (140), the channel layers (102) are first channel layers (102), and the insulator (110) is an inter-gate insulator (110),
wherein the integrated circuit device (10) further comprises a second transistor (160) that comprises second channel layers (112) that are spaced apart from each other in the first direction on the inter-gate insulator (110), and
wherein the inter-gate insulator (110) is between the first transistor (140) and the second transistor (160) in the first direction.

8. The integrated circuit device of claim 7, wherein a width (W2) of a lowermost one of the second channel layers (112) in the second direction is less than the width (W1) of the inter-gate insulator (100) in the second direction.

9. The integrated circuit device of claim 7 or 8, wherein the integrated circuit device (50) further comprises an upper insulator (1626) on the second transistor (1660),
wherein the second transistor (1660) is between the inter-gate insulator (1610) and the upper insulator (1626) in the first direction, and
wherein a width (W2) of an uppermost one of the second channel layers (1612) in the second direction is equal or substantially equal to a width (W2) of the upper insulator (1626) in the second direction.

10. The integrated circuit device of any one of claims 7 to 9, wherein each of the second channel layers (112) has an equal or a substantially equal width in the second direction.

11. The integrated circuit device of any one of claims 7 to 10, wherein the second transistor (160) further comprises a second gate structure (114, 116, 118) on the second channel layers (112) and the inter-gate insulator (110),
wherein the first gate structure (104, 106, 108) is in contact with the second gate structure (114, 116, 118), and
wherein side surfaces of the inter-gate insulator (110) are aligned with corresponding side surfaces of an uppermost one of the first channel layers (102), respectively.

12. The integrated circuit device of any one of claims 7 to 11, wherein the first transistor (140) has a first conductivity type, and
wherein the second transistor (160) has a second conductivity type that is different from the first conductivity type.

13. A method of forming an integrated circuit device, the method comprising:
forming (202) a first stack (342) on a substrate (!00), wherein the first stack (342) comprises first channel layers (102) and first sacrificial layers (320) that are alternately stacked;
forming (204) an inter-gate sacrificial layer (322) on the first stack (342);
forming (206) a second stack (362) on the inter-gate sacrificial layer (322), wherein the second stack (362) comprises second channel layers (112) and second sacrificial layers (320) that are alternately stacked; and
replacing (210) the inter-gate sacrificial layer (322) with an inter-gate insulator (110),
wherein a width (W1) of the inter-gate insulator (110) in a horizontal direction that is parallel with an upper surface of the substrate (100) is equal or substantially equal to a width (W1) of an uppermost one of the first channel layers (102) in the horizontal direction.

14. The method of Claim 13, further comprising:
removing (208) a portion of the second stack (362) to partially expose the inter-gate sacrificial layer (322) before the replacing the inter-gate sacrificial layer (322) with the inter-gate insulator (110);
removing (210) the first sacrificial layers (320) and the second sacrificial layers (320);
forming (214) a first gate structure (104, 106, 108) on the first channel layers (102) and the inter-gate insulator (110); and
forming (214) a second gate structure (114, 116, 118) on the second channel layers (112) and the inter-gate insulator (110),
wherein the first gate structure (104, 106, 108) is in contact with the second gate structure (114, 116, 118).

15. The method of Claim 14, further comprising:
forming (1708) an upper sacrificial layer (1828) on the second stack (1862) before the removing (1710) the portion of the second stack (1862);
removing (1710) a portion of the upper sacrificial layer (1828); and
replacing (1712) the upper sacrificial layer (1828) with an upper insulator (1626) before the removing (1714) the first sacrificial layers (1820) and the second sacrificial layers (1824).
